# EUROPÄISCHE PATENTSCHRIFT

(11) **EP 3 997 970 B1**
(45) Veröffentlichungstag und Bekanntmachung des Hinweises auf die Patenterteilung: **28.06.2023**
(21) Anmeldenummer: 20734149.6
(22) Anmeldetag: 18.06.2020
(51) Int. Cl.: G01D 21/00, H05K 5/02, H05K 7/14, G01D 11/24

(54) **GEHÄUSEMODUL UND FELDGERÄT**
HOUSING MODULE AND FIELD DEVICE
MODULE DE BOÎTIER ET APPAREIL DE TERRAIN

(30) Priorität: 11.07.2019 DE 102019118778
(43) Veröffentlichungstag der Anmeldung: 18.05.2022
(73) Patentinhaber: Endress + Hauser Flowtec AG, 4153 Reinach (CH)
(72) Erfinder: BEISSERT, Markus, 79424 Auggen (DE); MÜLLER, Harald, 36043 Fulda (DE); FIEDLER, Marc, 4153 Reinach (CH)
(74) Vertreter: Hahn, Christian
(86) Internationale Anmeldenummer: PCT/EP2020/066958
(87) Internationale Veröffentlichungsnummer: WO 2021/004754

(56) Entgegenhaltungen:
- EP-A2- 2 642 255
- WO-A1-2011/160949
- DE-A1- 10 126 654
- DE-A1-102014 106 540
- US-A1- 2009 315 278

## Beschreibung

Die Erfindung betrifft ein Gehäusemodul eines Feldgeräts der Mess- und Automatisierungstechnik und ein solches Feldgerät, wobei das Gehäusemodul mindestens zwei Gehäusekammern aufweist, wobei die Gehäusekammern durch eine Trennwand getrennt sind, wobei das Gehäusemodul die Zündschutzart Ex-d erfüllt.

Die WO2011160949A1 offenbart ein solches Gehäusemodul mit einer solchen Trennwand, wobei in einer ersten Gehäusekammer eine Mess- und Betriebselektronik angeordnet ist, und wobei in einer zweiten Gehäusekammer eine Anschlusselektronik angeordnet ist. Eine elektrische Verbindung ist dabei durch eine Öffnung der Trennwand geführt, wobei die Öffnung mit einem Verguss gefüllt ist um Anforderungen hinsichtlich der Zündschutzart Ex-d zu erfüllen.

Das Einrichten eines Vergusses ist aufwendig und verzögert die Fertigung, da eine Vergussmasse aushärten muss, bevor anschließende Fertigungsschritte durchgeführt werden können. Auch ist ein Austausch der elektrischen Verbindung oder ein Zugang zur Mess- und Betriebselektronik zwecks Überprüfung oder Austausch erschwert.

Die DE10126654A1 zeigt ein Gehäuse mit einem Anzeigemodul und zwei Öffnungen, wobei das Anzeigemodul in einer der beiden Öffnungen eingesetzt ist und die jeweils andere Öffnung durch eine Bodenplatte verschlossen ist.

Die DE102014106540A1 zeigt ein Feldgerät mit einem rohrförmigen Gehäusekörper, bei welchem ein Schließelement den Gehäusekörper im Bereich einer Stirnfläche verschließt.

Die US20090315278A1 zeigt ein Messsystem mit einem Gehäuse mit mehreren Abdichtungen.

Die EP2642255A2 zeigt ein Messgerät mit einem Gehäuse, in welchem eine modulare Elektronik eingesetzt ist.

Aufgabe der Erfindung ist es daher ein Gehäusemodul und ein Feldgerät mit einem solchen Gehäusemodul vorzuschlagen, bei welchem Fertigung sowie Wartung bei Einhaltung der Anforderungen der Zündschutzart Ex-d vereinfacht ist.

Die Aufgabe wird gelöst durch ein Gehäusemodul gemäß dem unabhängigen Anspruch 1 sowie durch ein Feldgerät gemäß dem unabhängigen Anspruch 12.

Ein erfindungsgemäßes Gehäusemodul eines Feldgeräts der Mess- und Automatisierungstechnik umfasst:
ein Gehäuse mit einer Gehäusewandung und einer ersten Gehäusekammer sowie einer zweiten Gehäusekammer, wobei die Gehäusekammern durch eine insbesondere lösbar befestigte Trennwand getrennt sind,
wobei in der ersten Gehäusekammer eine Mess-/Betriebselektronik des Feldgeräts angeordnet ist, und wobei in der zweiten Gehäusekammer eine Anschlusselektronik zum Anschließen von Leitungen zur Energieversorgung des Feldgeräts und/oder zum Austausch von Daten angeordnet ist,
wobei die Trennwand eine Durchgangsöffnung aufweist, wobei in der Durchgangsöffnung eine elektrische Durchführung zum Verbinden der Mess-/Betriebselektronik mit der Anschlusselektronik aufweist,
wobei die Durchführung Anforderungen der EX-d-Norm nach IEC60079-1 von 2014-06; EN60079-1 von 2014-06 entspricht,
wobei die Durchführung einen elektrisch isolierenden Trägerkörper mit einer Längsachse und mehrere elektrisch leitfähige Verbindungsvorrichtungen zur Bereitstellung der elektrischen Verbindung aufweist, wobei die Verbindungsvorrichtungen
durch Bohrungen oder Durchgangslöcher des Trägerkörpers verlaufen,
wobei die Bohrungen jeweils eine erste Ausdehnung entlang einer Bohrungsachse sowie jeweils einen Innendurchmesser aufweisen, wobei die Verbindungsvorrichtungen jeweils einen Außendurchmesser aufweisen, wobei die Verbindungsvorrichtung im Trägerkörper in Richtung der zweiten Gehäusekammer auf einer der ersten Gehäusekammer zugewandten Seite des Trägerkörpers formschlüssig gehalten sind,
wobei ein Verhältnis von einer Differenz zwischen Innendurchmesser der Bohrung und Außendurchmesser der zugehörigen Verbindungsvorrichtung zur ersten Ausdehnung kleiner ist als 0.05, und insbesondere kleiner ist als 0.025 und bevorzugt kleiner ist als 0.02,
wobei der Trägerkörper von einer der ersten Gehäusekammer zugewandten Seite der Trennwand in die Durchgangsöffnung eingesetzt ist und eine Flammendurchschlagssperre gemäß der EX-d-Norm bildet.

In einer Ausgestaltung ist zumindest eine Verbindungsvorrichtung eines der folgenden:
ein Stift, insbesondere ein Metallstift;
eine Hochfrequenzdurchleitung,
wobei der Stift bzw. die Hochfrequenzdurchleitung Kontaktierungselemente zwecks Kontaktierung mit der elektronischen Mess-/Betriebsschaltung und der Anschlusselektronik umfasst.

In einer Ausgestaltung weist die Hochfrequenzleitung eine elektrisch leitfähige Hülse, einen in der Hülse angeordneten Innenleiter und eine elektrische Isolierung auf, welche den Innenleiter elektrisch von der Hülse trennt wobei die elektrische Isolierung ein Dielektrikum wie beispielsweise PTFE umfasst. Die elektrische Isolierung sollte dabei den Anforderungen des Standards IEC60079-0, IEC60079-7 und IEC60079-11 sowie EN60079-0, EN60079-7 und EN60079-11 entsprechen.

In einer Ausgestaltung ist eine Innenwandung der Durchgangsöffnung von einer in der Durchgangsöffnung befindlichen Mantelfläche des Trägerkörpers durch einen den Trägerkörper umgreifenden Spalt getrennt,
wobei der Spalt eine Spaltbreite bemessen durch einen durchschnittlichen Abstand zwischen Mantelfläche und Innenwandung der Durchgangsöffnung aufweist, und wobei der Spalt in einer einen Längsschnitt des Trägerkörpers enthaltende Ebene eine Pfadlänge aufweist,
wobei ein Verhältnis Spaltbreite zu Pfadlänge kleiner ist als 0.05, und insbesondere kleiner ist als 0.025 und bevorzugt kleiner ist als 0.02.

In einer Ausgestaltung weist der Trägerkörper auf einer zur ersten Gehäusekammer gerichteten Seite eine Schulter auf, wobei die Schulter dazu geeignet ist, eine formschlüssige Verbindung mit einer Umrandung der Durchgangsöffnung einzugehen,
wobei die Schulter dazu geeignet ist, den Trägerkörper drucktragend zu halten.

In einer Ausgestaltung ist die Umrandung der Durchgangsöffnung eine Aussparung in der Trennwand, welche die Schulter in Richtung der Längsachse des Trägerkörpers vollständig aufnimmt.

In einer Ausgestaltung weist ein der ersten Gehäusekammer zugewandter Abschnitt der in der Durchgangsöffnung befindlichen Mantelfläche einen ersten Umfang auf, wobei ein der zweiten Gehäusekammer zugewandter Abschnitt der in der Durchgangsöffnung befindlichen Mantelfläche einen zweiten Umfang aufweist, wobei der erste Umfang größer ist als der zweite Umfang.

In einer Ausgestaltung ist der Trägerkörper aus einem Kunststoff insbesondere mittels Spritzgießen gefertigt ist.

In einer Ausgestaltung sind die Verbindungsvorrichtungen in die Bohrungen eingepresst.

In einer Ausgestaltung ist der Außendurchmesser der Verbindungsvorrichtungen entlang einer Längsachse der Verbindungsvorrichtung variierend.

In einer Ausgestaltung ist die Trennwand in das Gehäuse eingesetzt, so dass die zwei Gehäusekammern bei Einsetzen der Trennwand gebildet werden.

Ein erfindungsgemäßes Feldgerät der Mess- und Automatisierungstechnik umfasst:
Ein Gehäusemodul wie oben beschrieben;
Einen Messumformer zum Erfassen mindestens einer Messgröße und zum Bereitstellen eines die Messgröße repräsentierenden Messsignals,
wobei die elektronische Mess-/Betriebselektronik dazu eingerichtet ist, mittels des Messsignals Messwerte der Messgröße zu bestimmen und bereitzustellen.

Im Folgenden wird die Erfindung anhand von Ausführungsbeispielen beschrieben.
Fig. 1 skizziert einen Querschnitt durch ein beispielhaftes erfindungsgemäßes Gehäusemodul;
Fig. 2 a) bis c) stellen eine beispielhafte erfindungsgemäße elektrische Durchführung mit einem Trägerkörper mit Verbindungsvorrichtungen dar;
Fig. 3 a) bis c) stellen eine beispielhafte erfindungsgemäße elektrische Durchführung mit einem Trägerkörper mit Verbindungsvorrichtungen dar;
Fig. 4 zeigt einen schematischen Aufbau eines Feldgeräts mit einem erfindungsgemäßen Gehäusemodul.

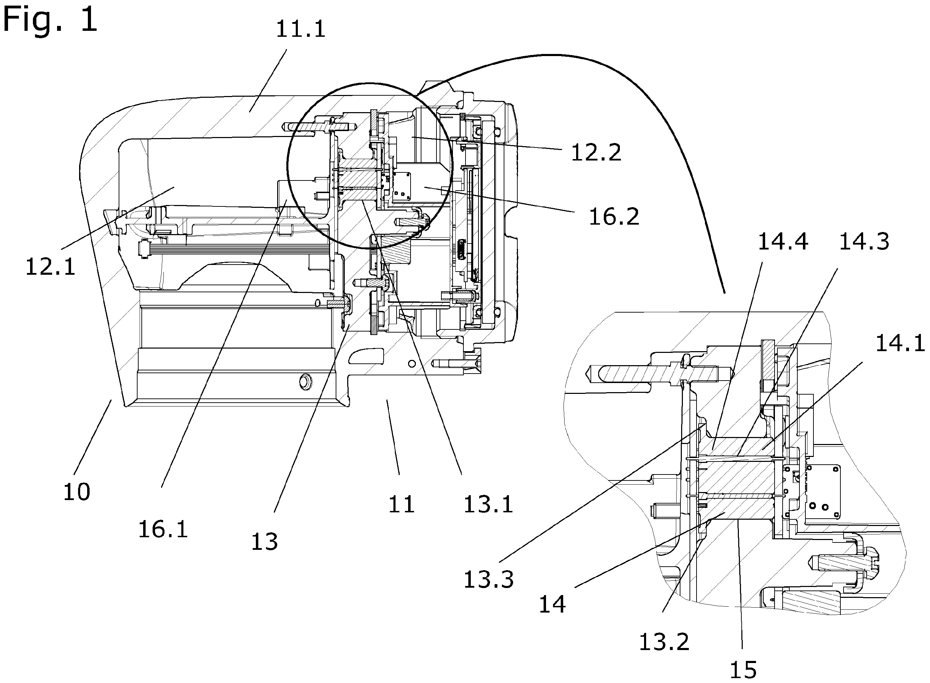

Fig. 1 skizziert einen Querschnitt durch ein Gehäusemodul 10 eines Feldgeräts 1 der Mess- und Automatisierungstechnik mit einem Gehäuse 11 mit einer Gehäusewandung 11.1, welches Gehäuse eine erste Gehäusekammer 12.1 und eine zweite Gehäusekammer 12.2 umfasst, welche durch eine Trennwand 13 getrennt sind. Die Trennwand weist eine Durchgangsöffnung 13.1 auf.

In der ersten Gehäusekammer 12.1 ist eine Mess-/Betriebselektronik 16.1 angeordnet, und in der zweiten Gehäusekammer ist eine Anschlusselektronik 16.2 angeordnet. Die Mess-/Betriebselektronik ist dazu eingerichtet, Messsignale eines Messumformers aufzunehmen und Messwerte zu einer durch die Messsignale repräsentierten Messgröße bereitzustellen. Die Anschlusselektronik ist beispielsweise dazu eingerichtet, ein Auslesen der Messwerte oder ein Anschließen einer Versorgungsleitung zu ermöglichen. Die Mess-/Betriebselektronik und die Anschlusselektronik sind mittels einer elektrischen Durchführung 14 verbunden, welche elektrische Durchführung in der Durchgangsöffnung angeordnet ist.

Die Trennung der ersten Gehäusekammer von der zweiten Gehäusekammer erfüllt dabei die Ex-d-Norm nach IEC60079-1 von 2014-06; EN60079-1 von 2014-06 entspricht, wobei die Trennwand sowie die in die Durchgangsöffnung eingesetzte elektrische Durchführung eine Flammendurchschlagssperre bilden.

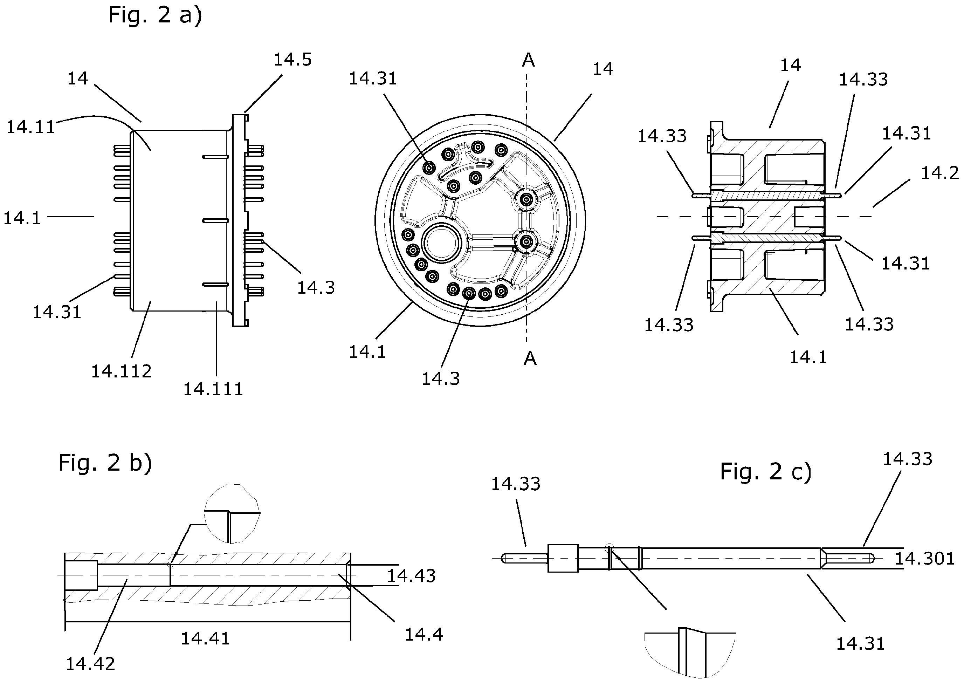

Die elektrische Durchführung 14 weist einen elektrisch isolierenden Trägerkörper 14.1 mit einer Längsachse 14.2 und einer Mantelfläche 14.11 auf, wobei der Trägerkörper wie hier gezeigt auf einer der ersten Gehäusekammer zugewandten Seite eine Schulter 14.5 aufweisen kann, welche Schulter dazu geeignet ist, eine formschlüssige Verbindung mit einer Umrandung 13.2 der Durchgangsöffnung einzugehen, wobei die Schulter dazu eingerichtet ist, den Trägerkörper drucktragend zu halten. Die Schulter kann dabei wie hier dargestellt in einer Aussparung 13.3 der Trennwand versenkt sein, welche Aussparung die Umrandung 13.2 ausbildet. Der Trägerkörper weist des Weiteren Bohrungen 14.4 auf, in welchen elektrisch leitfähige Verbindungsvorrichtungen 14.3 zur Verbindung der elektronischen Mess-/Betriebsschaltung 16.1 mit der Anschlusselektronik 16.2 angeordnet sind. Erfindungsgemäß ist ein Verhältnis von einer Differenz zwischen einem Innendurchmesser 14.43 der Bohrung und Außendurchmesser 14.301 der zugehörigen Verbindungsvorrichtung zu einer ersten Ausdehnung 14.41 der Bohrung entlang einer Bohrungsachse 14.42 kleiner ist als 0.05, und insbesondere kleiner ist als 0.025 und bevorzugt kleiner ist als 0.02, siehe dazu auch Fig. 2 b). Auf

diese Weise bildet der Trägerkörper im Hinblick auf die Verbindungsvorrichtungen eine Flammendurchschlagssperre gemäß der Ex-d-Norm.

In einer Ausgestaltung ist der Trägerkörper von der Trennwand durch einen Spalt getrennt, wobei ein Verhältnis von einer Spaltbreite zu einer Spaltlänge kleiner ist als 0.05, und insbesondere kleiner ist als 0.025 und bevorzugt kleiner ist als 0.02. Die Spaltbreite ist bemessen durch einen durchschnittlichen Abstand zwischen Mantelfläche und Innenwandung der Durchgangsöffnung aufweist, wobei der Spalt in einer einen Längsschnitt des Trägerkörpers enthaltende Ebene eine Pfadlänge aufweist, wobei die Pfadlänge die Spaltlänge bemisst.

Fig. 2 a) zeigt auf detaillierte Weise von links nach rechts eine Seitenansicht auf eine beispielhafte erfindungsgemäße elektrische Durchführung 14 wie in Fig. 1 schematisch dargestellt mit einem Trägerkörper 14.1, eine Aufsicht auf die Durchführung und einen Schnitt durch die Durchführung entlang der in der Aufsicht angedeuteten Ebene A. Der Trägerkörper weist eine Längsachse 14.2 auf, wobei in Bohrungen 14.4 des Trägerkörpers jeweils ein Verbindungselement 14.1 zwecks elektrischer Verbindung der Mess-/Betriebselektronik 16.1 mit der Anschlusselektronik 16.2 angeordnet ist. Die Verbindungselemente sind in diesem Ausführungsbeispiel elektrisch leitfähige Stifte 14.31, insbesondere Metallstifte, welche in die Bohrungen eingepresst sind. Da das Verhältnis von der Differenz zwischen Innendurchmesser der Bohrung und Außendurchmesser der Verbindungsvorrichtung, hier ein Stift, zur ersten Ausdehnung kleiner ist als 0.05, und insbesondere kleiner ist als 0.025 und bevorzugt kleiner ist als 0.02 ist, liegt eine Passung vor zwischen Stift und Bohrung. Eine in der ersten Gehäusekammer entstehende Flammenfront kann nicht bis zur zweiten Gehäusekammer vordringen, so dass die Verbindungselemente in den Bohrungen eine Flammendurchschlagssperre gemäß der Ex-d-Norm bilden.

Eine Mantelfläche 14.11 des Trägerkörpers kann wie hier dargestellt in einem der ersten Gehäusekammer zuzuwendenden Abschnitt 14.111 einen größeren Umfang aufweisen, als in einem zweiten Abschnitt 14.112. Der größere Umfang kann dabei wie hier dargestellt mittels Rippen oder auch durch eine umlaufende, durchgehende Verbreiterung des Trägerkörpers gegeben sein. Auf diese Weise kann der Trägerkörper einfach über eine Spielpassung in die Gehäusewand eingesetzt werden, welche Spielpassung beispielsweise in eine Presspassung übergeht.

Die Verbindungsvorrichtungen 14.3 können wie in der Aufsicht gezeigt in mehreren Gruppen angeordnet werden, um beispielsweise eigensichere Verbindungen (gemäß IEC60079-11) zum Übertragen von erhöhten Leistungen von anderen nicht eigensicheren Verbindungen zu trennen.

Fig. 2 b) zeigt einen detaillierten Ausschnitt durch den Trägerkörper entlang einer Bohrung 14.4. Die Bohrung kann entlang der Bohrungsachse 14.42 einen variierenden Innendurchmesser 14.43 aufweisen. Falls der Stift wie in Fig. 2 c) gezeigt entlang einer Längsachse einen variierenden Außendurchmesser 14.301 aufweist, welcher zumindest abschnittsweise komplementär zum Innendurchmesser 14.43 ist, dann kann der Stift in der Bohrung präzise platziert werden.

Die Verbindungsvorrichtungen 14.3, hier Stifte weisen Kontaktierungselemente 14.33 auf zur elektrischen Kontaktierung mit der Mess-/Betriebselektronik 16.1 sowie mit der Anschlusselektronik 16.2.

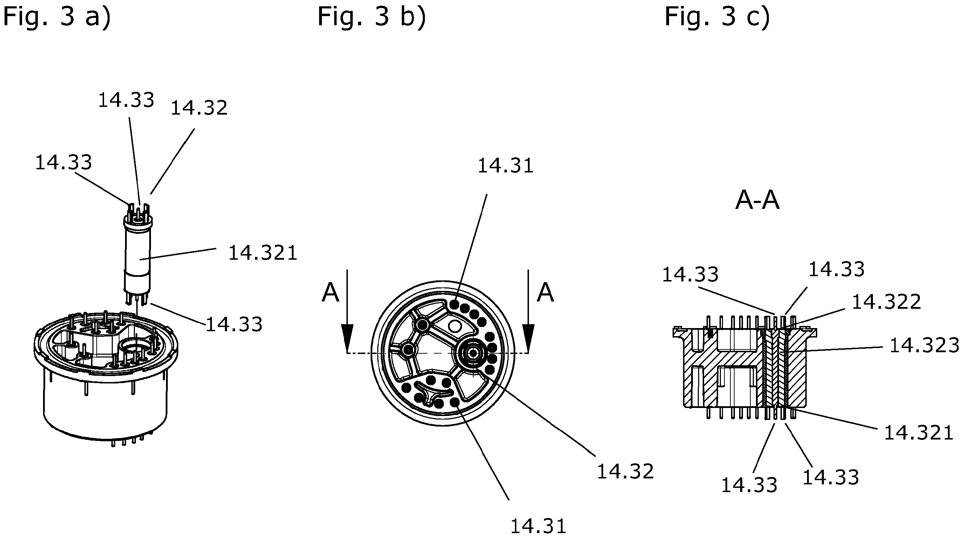

Figs. 3 a) bis c) zeigen auf detaillierte Weise von links nach rechts eine Seitenansicht auf eine beispielhafte erfindungsgemäße elektrische Durchführung 14 wie in Fig. 1 schematisch dargestellt mit einem Trägerkörper 14.1, eine Aufsicht auf die Durchführung und einen Schnitt durch die Durchführung entlang der in der Aufsicht angedeuteten Ebene A.

Im Unterschied zur in Figs. 2 a) bis c) gezeigten Durchführung weist die Durchführung eine Hochfrequenzdurchleitung 14.32 auf. Eine Hochfrequenzdurchleitung umfasst eine Hülse 14.321, einen Inneneiter 14.322, welcher insbesondere koaxial zur Hülse verläuft, und eine elektrische Isolierung 14.323 zur elektrischen Trennung von Hülse und Innenleiter. Das zur in Figs. 2 a) bis 2 c) Gesagte gilt auch für die in Fig. 3 gezeigte Ausgestaltung.

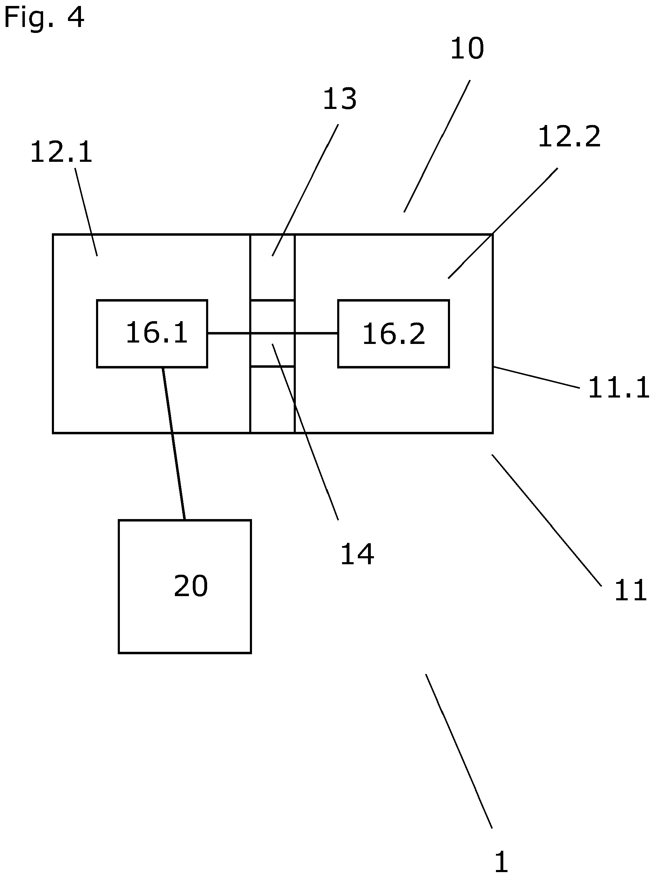

Fig. 4 skizziert einen schematischen beispielhaften Aufbau eines Feldgeräts 1 der Mess- und Automatisierungstechnik, welches ein erfindungsgemäßes Gehäusemodul 10 mit einem Gehäuse 11 aufweist, welches Gehäuse durch eine Gehäusewand 11.1 ausgebildet wird. Das Gehäusemodul weist eine erste Gehäusekammer 12.1 und eine zweite Gehäusekammer 12.2 auf, welche durch eine Trennwand 13 getrennt sind. Die Trennwand kann dabei lösbar befestigt eingerichtet sein. In der ersten Gehäusekammer ist eine elektronische Mess-/Betriebsschaltung 16.1 angeordnet, welche dazu eingerichtet ist, einen Messumformer 20 des Feldgeräts zu betreiben, und in der zweiten Gehäusekammer ist eine Anschlusselektronik 16.2 angeordnet. Eine erfindungsgemäße Durchführung 14 wie oben beschrieben ist dazu eingerichtet, die Mess-/Betriebselektronik mit der Anschlusselektronik elektrisch zu verbinden.

### Bezugszeichenliste

- 1: Feldgerät
- 10: Gehäusemodul
- 11: Gehäuse
- 11.1: Gehäusewandung
- 12.1: erste Gehäusekammer
- 12.2: zweite Gehäusekammer
- 13: Trennwand
- 13.1: Durchgangsöffnung
- 13.11: Innenwandung
- 13.2: Umrandung
- 13.3: Aussparung
- 14: elektrische Durchführung
- 14.1: elektrisch isolierender Trägerkörper
- 14.11: Mantelfläche
- 14.111: erster Abschnitt
- 14.112: zweiter Abschnitt
- 14.2: Längsachse
- 14.3: Verbindungsvorrichtung
- 14.301: Außendurchmesser
- 14.31: Stift
- 14.32: Hochfrequenzdurchleitung
- 14.321: Hülse
- 14.322: Innenleiter
- 14.323: elektrische Isolierung
- 14.33: Kontaktierungselement
- 14.4: Bohrung
- 14.41: erste Ausdehnung
- 14.42: Bohrungsachse
- 14.43: Innendurchmesser
- 14.5: Schulter
- 15: Spalt
- 15.1: Spaltbreite
- 16.1: Mess-/Betriebselektronik
- 16.2: Anschlusselektronik
- 20: Messumformer

## Patentansprüche

1. Gehäusemodul (10) eines Feldgeräts (1) der Mess- und Automatisierungstechnik umfassend:
ein Gehäuse (11) mit einer Gehäusewandung (11.1) und einer ersten Gehäusekammer (12.1) sowie einer zweiten Gehäusekammer (12.2), wobei die Gehäusekammern durch
eine insbesondere lösbar befestigte Trennwand (13) getrennt sind,
wobei in der ersten Gehäusekammer eine Mess-/Betriebselektronik (16.1) des Feldgeräts angeordnet ist, und wobei in der zweiten Gehäusekammer eine Anschlusselektronik (16.2) zum Anschließen von Leitungen zur Energieversorgung des Feldgeräts und/oder zum Austausch von Daten angeordnet ist,
wobei die Trennwand eine Durchgangsöffnung (13.1) aufweist, wobei in der
Durchgangsöffnung eine elektrische Durchführung (14) zum Verbinden der Mess-/Betriebselektronik mit der Anschlusselektronik angeordnet ist,
wobei die Durchführung Anforderungen der Ex-d-Norm nach IEC60079-1 von 2014-06, EN60079-1 von 2014-06 entspricht,
wobei die Durchführung einen elektrisch isolierenden Trägerkörper (14.1) mit einer Längsachse (14.2) und mehrere elektrisch leitfähige Verbindungsvorrichtungen (14.3) zur Bereitstellung der elektrischen Verbindung aufweist, wobei die Verbindungsvorrichtungen
durch Bohrungen oder Durchgangsöffnungen (14.4) des Trägerkörpers verlaufen, wobei die Bohrungen jeweils eine erste Ausdehnung (14.41) entlang einer Bohrungsachse (14.42) sowie jeweils einen Innendurchmesser (14.43) aufweisen, wobei die Verbindungsvorrichtungen jeweils einen Außendurchmesser (14.301) aufweisen,
wobei die Verbindungsvorrichtungen im Trägerkörper in Richtung der zweiten Gehäusekammer auf einer der ersten Gehäusekammer zugewandten Seite des Trägerkörpers formschlüssig gehalten sind,
**dadurch gekennzeichnet, dass** ein Verhältnis von einer Differenz zwischen Innendurchmesser der Bohrung und Außendurchmesser der zugehörigen Verbindungsvorrichtung zur ersten Ausdehnung (14.41) kleiner ist als
0.05, und insbesondere kleiner ist als 0.025 und bevorzugt kleiner ist als 0.02,
wobei der Trägerkörper von einer der ersten Gehäusekammer zugewandten Seite der Trennwand in die Durchgangsöffnung eingesetzt ist und eine Flammendurchschlagssperre gemäß der Ex-d-Norm bildet.

2. Gehäusemodul nach Anspruch 1,
wobei zumindest eine Verbindungsvorrichtung eines der folgenden ist:
ein Stift (14.31), insbesondere ein Metallstift;
eine Hochfrequenzdurchleitung (14.32),
wobei der Stift bzw. die Hochfrequenzdurchleitung Kontaktierungselemente (14.33) zwecks Kontaktierung mit der elektronischen Mess-/Betriebsschaltung und der Anschlusselektronik umfasst.

3. Gehäusemodul nach Anspruch 2,
wobei die Hochfrequenzleitung eine elektrisch leitfähige Hülse (14.321), einen in der Hülse angeordneten Innenleiter (14.322) und eine elektrische Isolierung (14.322) aufweist, welche den Innenleiter elektrisch von der Hülse trennt,
wobei die elektrische Isolierung ein Dielektrikum wie beispielsweise PTFE umfasst.

4. Gehäusemodul nach einem der vorigen Ansprüche,
wobei eine Innenwandung (13.11) der Durchgangsöffnung von einer in der Durchgangsöffnung befindlichen Mantelfläche (14.11) des Trägerkörpers durch einen den Trägerkörper umgreifenden Spalt (15) getrennt ist,
wobei der Spalt eine Spaltbreite (15.1) bemessen durch einen durchschnittlichen Abstand zwischen Mantelfläche und Innenwandung der Durchgangsöffnung aufweist, und wobei der Spalt in einer einen Längsschnitt des Trägerkörpers enthaltende Ebene eine Pfadlänge aufweist,
wobei ein Verhältnis Spaltbreite zu Pfadlänge
kleiner ist als 0.05, und insbesondere kleiner ist als 0.025 und bevorzugt kleiner ist als 0.02.

5. Gehäusemodul nach Anspruch 4,
wobei der Trägerkörper auf einer zur ersten Gehäusekammer gerichteten Seite eine Schulter (14.5) aufweist, wobei die Schulter dazu geeignet ist, eine formschlüssige Verbindung mit einer Umrandung (13.2) der Durchgangsöffnung einzugehen, wobei die Schulter dazu geeignet ist, den Trägerkörper drucktragend zu halten.

6. Gehäusemodul nach Anspruch 5,
wobei die Umrandung (13.2) der Durchgangsöffnung eine Aussparung (13.3) in der Trennwand ist, welche die Schulter in Richtung der Längsachse des Trägerkörpers vollständig aufnimmt.

7. Gehäusemodul nach einem der Ansprüche 4 bis 6,
wobei ein der ersten Gehäusekammer (12.1) zugewandter erster Abschnitt (14.111) der in der Durchgangsöffnung befindlichen Mantelfläche einen ersten Umfang aufweist, und wobei ein der zweiten Gehäusekammer (12.2) zugewandter zweiter Abschnitt (14.112) der in der Durchgangsöffnung befindlichen Mantelfläche einen zweiten Umfang aufweist,
wobei der erste Umfang größer ist als der zweite Umfang.

8. Gehäusemodul nach einem der vorigen Ansprüche,
wobei der Trägerkörper (14.1) aus einem Kunststoff insbesondere mittels Spritzgießen gefertigt ist.

9. Gehäusemodul nach Anspruch 8,
wobei die Verbindungsvorrichtungen (14.3) in die Bohrungen eingepresst sind.

10. Gehäusemodul nach Anspruch 9,
wobei der Außendurchmesser der Verbindungsvorrichtungen entlang einer Längsachse der Verbindungsvorrichtung variierend ist.

11. Gehäusemodul nach einem der vorigen Ansprüche,
wobei die Trennwand (13) in das Gehäuse eingesetzt ist, so dass die zwei Gehäusekammern bei Einsetzen gebildet werden.

12. Feldgerät (1) der Mess- und Automatisierungstechnik umfassend:
Ein Gehäusemodul (10) nach einem der vorigen Ansprüche;
Einen Messumformer (20) zum Erfassen mindestens einer Messgröße und zum Bereitstellen eines die Messgröße repräsentierenden Messsignals,
wobei die elektronische Mess-/Betriebselektronik (16.1) dazu eingerichtet ist, mittels des Messsignals Messwerte der Messgröße zu bestimmen und bereitzustellen.

## Claims

1. Housing module (10) of a field device (1) used in measuring and automation technology, comprising:
a housing (11) with a housing wall (11.1) and a first housing chamber (12.1) and a second housing chamber (12.2), wherein the housing chambers are separated particularly by a detachable partition wall (13),
wherein a measuring/operating electronics unit (16.1) of the field device is arranged in the first housing chamber, and wherein a connection electronics unit (16.2) to connect cables to the energy supply system of the field device and/or to exchange data is arranged in the second housing chamber,
wherein the partition wall has a through opening (13.1), wherein an electrical feedthrough (14) to connect the measuring/operating electronics unit to the connection electronics unit is arranged in the through opening,
wherein the feedthrough satisfies requirements of the Ex-d standard according to IEC60079-1 of 2014-06, EN60079-1 of 2014-06,
wherein the feedthrough has an electrically isolating support body (14.1) with a longitudinal axis (14.2) and several electrically conductive connection units (14.3) to provide the electrical connection,
wherein the connection units pass through bores or through openings (14.4) of the support body,
wherein the bores each have a first extension (14.41) along a bore axis (14.42) and an internal diameter (14.43), wherein the connection units each have an outer diameter (14.301),
wherein the connection units are held with positive locking in the support body in the direction of the second housing chamber on a side of the support body facing towards the first housing chamber,
**characterized in that** a ratio of a difference between the inner diameter of the bore and the outer diameter of the associated connection unit to the first extension (14.41) is less than 0.05 and
particularly less than 0.025 and preferably less than 0.02,
wherein the support body of a side of the partition wall facing towards the first housing chamber is introduced into the through opening and forms a flame barrier according to the Ex-d standard.

2. Housing module as claimed in Claim 1,
wherein at least one connection unit is one of the following:
a pin (14.31), particularly a metal pin;
a high-frequency line (14.32),
wherein the pin or the high-frequency line comprises contact elements (14.33) for the purpose of establishing contact with the electronic measuring/operating circuit and the connection electronics.

3. Housing module as claimed in Claim 2,
wherein the high-frequency line has an electrically conductive sleeve (14.321), and internal conductor (14.322) arranged in the sleeve and an electrical insulation (14.322), which electrically insulates the internal conductor from the sleeve,
wherein the electrical insulation comprises a dielectric such as PTFE.

4. Housing module as claimed in one of the previous claims,
wherein an inner wall (13.11) of the through opening is separated from a lateral surface (14.11) of the support body located in the through opening by a gap (15) surrounding the support body,
wherein the gap has a gap width (15.1) determined by an average distance between the lateral surface and inner wall of the through opening, and wherein the gap has a path length on a plane containing a longitudinal section of the support body,
wherein a ratio of the gap width to the path length is less than 0.05, and particularly less than 0.025 and preferably less than 0.02.

5. Housing module as claimed in Claim 4,
wherein the support body has a shoulder (14.5) on a side facing towards the first housing chamber, wherein the shoulder is suitable for forming a positive locking connection with a border (13.2) of the through opening,
wherein the shoulder is suitable for holding the support body in a pressure-bearing manner.

6. Housing module as claimed in Claim 5,
wherein the border (13.2) of the through opening is a recess (13.3) in the partition wall which fully accommodates the shoulder in the direction of the longitudinal axis of the support body.

7. Housing module as claimed in one of the Claims 4 to 6,
wherein a first section (14.111) of the lateral surface located in the through opening and facing towards the first housing chamber (12.1) has a first circumference, and wherein a second section (14.112) of the lateral surface located in the through opening and facing towards the second housing chamber (12.1) has a second circumference,
wherein the first circumference is greater than the second circumference.

8. Housing module as claimed in one of the previous claims,
wherein the support body (14.1) is made from a plastic, particularly using injection molding.

9. Housing module as claimed in Claim 8,
wherein the connection units (14.3) are pressed into the bores.

10. Housing module as claimed in Claim 9,
wherein the outer diameter of the connection units varies along a longitudinal axis of the connection unit.

11. Housing module as claimed in one of the previous claims,
wherein the partition wall (13) is introduced into the housing in such a way that the two housing chambers are formed when introduced.

12. Field device (1) used in measuring and automation technology comprising:
a housing module (10) as claimed in one of the previous claims;
a transmitter (20) for measuring at least a measured variable and for providing a measuring signal representing the measured variable,
wherein the electronic measuring/operating electronics unit (16.1) is configured to determine and
make available measured values of the measured variable using the measuring signal.

## Revendications

1. Module de boîtier (10) d'un appareil de terrain (1) de la technique de mesure et d'automatisation, lequel module comprend :
un boîtier (11) avec une paroi de boîtier (11.1) et une première chambre de boîtier (12.1) ainsi qu'une deuxième chambre de boîtier (12.2), les chambres de boîtier étant séparées par une paroi de séparation (13) fixée notamment de manière amovible,
une électronique de mesure/d'exploitation (16.1) de l'appareil de terrain étant disposée dans la première chambre de boîtier, et une électronique de raccordement (16.2) étant disposée dans la deuxième chambre de boîtier,
laquelle électronique de raccordement est destinée au raccordement de lignes pour l'alimentation en énergie de l'appareil de terrain et/ou pour l'échange de données,
la paroi de séparation présentant une ouverture de passage (13.1), une traversée électrique (14) étant disposée dans l'ouverture de passage pour relier l'électronique de mesure/d'exploitation à l'électronique de raccordement,
la traversée répondant aux exigences de la norme Ex-d selon IEC60079-1 de 2014-06,
la traversée présentant un corps de support (14.1) électriquement isolant avec un axe longitudinal (14.2) et plusieurs dispositifs de liaison (14.3) électriquement conducteurs pour assurer la liaison électrique, les dispositifs de liaison s'étendant à travers des alésages ou des ouvertures de passage (14.4) du corps de support,
les alésages présentant chacun une première extension (14.41) le long d'un axe d'alésage (14.42) ainsi qu'un diamètre intérieur (14.43),
les dispositifs de liaison présentant chacun un diamètre extérieur (14.301),
les dispositifs de liaison étant maintenus par complémentarité de forme dans le corps de support en direction de la deuxième chambre de boîtier sur un côté du corps de support tourné vers la première chambre de boîtier,
**caractérisé en ce qu'**un rapport entre une différence entre le diamètre intérieur de l'alésage et le diamètre extérieur du dispositif de liaison associé et la première extension (14.41) est inférieur à 0,05, et est notamment inférieur à 0,025 et de préférence inférieur à 0,02,
le corps de support étant inséré dans l'ouverture de passage à partir d'un côté de la cloison faisant face à la première chambre de boîtier et formant un dispositif pare-flammes selon la norme Ex-d.

2. Module de boîtier selon la revendication 1,
pour lequel au moins un dispositif de liaison est l'un des suivants :
une broche (14.31), notamment une broche métallique ;
une ligne de transmission haute fréquence (14.32),
la broche ou la ligne de transmission haute fréquence comprenant des éléments de contact (14.33) en vue d'un contact avec le circuit électronique de mesure/d'exploitation et l'électronique de raccordement.

3. Module de boîtier selon la revendication 2,
pour lequel la ligne de transmission haute fréquence comprend un manchon électriquement conducteur (14.321), un conducteur interne (14.322) disposé dans le manchon et une isolation électrique (14.322) qui sépare électriquement le conducteur interne du manchon, l'isolation électrique comprenant un diélectrique tel que du PTFE.

4. Module de boîtier selon l'une des revendications précédentes,
pour lequel une paroi intérieure (13.11) de l'ouverture de passage est séparée d'une surface d'enveloppe (14.11) du corps de support se trouvant dans l'ouverture de passage par une fente (15) entourant le corps de support,
la fente présentant une largeur de fente (15.1) mesurée par une distance moyenne entre la surface d'enveloppe et la paroi intérieure de l'ouverture de passage, et la fente présentant une longueur de chemin dans un plan contenant une coupe longitudinale du corps de support,
un rapport largeur de fente / longueur de fente étant inférieur à 0,05, et notamment inférieur à 0,025 et de préférence inférieur à 0,02.

5. Module de boîtier selon la revendication 4,
pour lequel le corps de support présente un épaulement (14.5) sur un côté orienté vers la première chambre de boîtier, l'épaulement étant conçu pour former une liaison par complémentarité de forme avec une bordure (13.2) de l'ouverture de passage, l'épaulement étant adapté pour maintenir le corps de support en supportant la pression.

6. Module de boîtier selon la revendication 5,
pour lequel la bordure (13.2) de l'ouverture de passage est un évidement (13.3) dans la paroi de séparation, lequel évidement reçoit complètement l'épaulement dans la direction de l'axe longitudinal du corps de support.

7. Module de boîtier selon l'une des revendications 4 à 6,
pour lequel une première section (14.111), tournée vers la première chambre de boîtier (12.1), de la surface d'enveloppe se trouvant dans l'ouverture de passage présente un premier périmètre, et
pour lequel une deuxième section (14.112), tournée vers la deuxième chambre de boîtier (12.2), de la surface d'enveloppe se trouvant dans l'ouverture de passage présente un deuxième périmètre,
le premier périmètre étant plus grand que le deuxième périmètre.

8. Module de boîtier selon l'une des revendications précédentes,
pour lequel le corps de support (14.1) est fabriqué en une matière plastique, notamment par moulage par injection.

9. Module de boîtier selon la revendication 8,
pour lequel les dispositifs de liaison (14.3) sont enfoncés dans les alésages.

10. Module de boîtier selon la revendication 9,
pour lequel le diamètre extérieur des dispositifs de liaison varie le long d'un axe longitudinal du dispositif de liaison.

11. Module de boîtier selon l'une des revendications précédentes,
pour lequel la cloison (13) est insérée dans le boîtier, de sorte que les deux chambres de boîtier sont formées lors de l'insertion.

12. Appareil de terrain (1) de la technique de mesure et d'automatisation, lequel appareil comprend :
Un module de boîtier (10) selon l'une des revendications précédentes,
Un transmetteur (20) destiné à mesurer au moins une grandeur de mesure et à fournir un signal de mesure représentant la grandeur de mesure,
l'électronique de mesure/d'exploitation (16.1) étant conçue pour déterminer et
fournir des valeurs mesurées de la grandeur de mesure au moyen du signal de mesure.
